# FASCICULE DE BREVET EUROPEEN

(11) **EP 3 325 985 B1**
(45) Date de publication et mention de la délivrance du brevet: **06.04.2022**
(21) Numéro de dépôt: 16757289.0
(22) Date de dépôt: 20.07.2016
(51) Int. Cl.: G01R 29/08

(54) **DISPOSITIF POUR LA DOSIMETRIE ELECTROMAGNETIQUE ET METHODE ASSOCIEE**
VORRICHTUNG FÜR ELEKTROMAGNETISCHE DOSIMETRIE UND ZUGEHÖRIGES VERFAHREN
DEVICE FOR ELECTROMAGNETIC DOSIMETRY AND ASSOCIATED METHOD

(30) Priorité: 24.07.2015 FR 1501595
(43) Date de publication de la demande: 30.05.2018
(73) Titulaire: Université de Rennes I, 35065 Rennes Cedex (FR); CENTRE NATIONAL DE LA RECHERCHE SCIENTIFIQUE (CNRS), 75016 Paris (FR)
(72) Inventeur: ZHADOBOV, Maxim, 35830 Betton (FR); BORISKIN, Artem, 35235 Thorigne-Fouillard (FR)
(74) Mandataire: Novagraaf Technologies
(86) Numéro de dépôt international: PCT/FR2016/051880
(87) Numéro de publication internationale: WO 2017/017350

(56) Documents cités:
- FR-A1- 2 851 823
- US-A1- 2004 017 115
- US-A1- 2013 099 119
- GURALIUC ANDA R ET AL: "Solid Phantom for Body-Centric Propagation Measurements at 60 GHz", IEEE TRANSACTIONS ON MICROWAVE THEORY AND TECHNIQUES, IEEE SERVICE CENTER, PISCATAWAY, NJ, US, vol. 62, no. 6, 1 juin 2014 (2014-06-01), pages 1373-1380, XP011549851, ISSN: 0018-9480, DOI: 10.1109/TMTT.2014.2320691 [extrait le 2014-06-02] cité dans la demande

## Description

### 1. Domaine de l'invention.

L'invention se rapporte au domaine de la dosimétrie électromagnétique et plus particulièrement à la mesure des grandeurs dosimétriques électromagnétiques dans et à la surface du corps humain.

### 2. Etat de l'art.

La mise sur le marché de systèmes et dispositifs émettant des ondes électromagnétiques à des puissances d'émission variées requiert d'obtenir un certain nombre de certifications dont certaines visent à garantir la conformité de ces dispositifs aux limites d'exposition des utilisateurs.

Différentes méthodes et techniques d'évaluation de l'exposition du corps humain aux ondes électromagnétiques existent et varient notamment en fonction de la bande de fréquences utilisée. Lorsque la fréquence est élevée, la profondeur de pénétration des ondes dans les tissus biologiques (y compris dans les tissus humains) diminue. Il devient alors pertinent de s'intéresser plus particulièrement au niveau d'exposition à un rayonnement électromagnétique donné à la surface des tissus ou au niveau des couches de l'épiderme (et plus largement de la peau dans son ensemble). Des systèmes de transmissions de données récents (y compris sans fil) opèrent à des fréquences élevées allant jusqu'à plusieurs dizaines de gigahertz. Ces fréquences n'existant pas dans la nature, leurs effets sur les tissus humains demeurent encore peu connus ou peu caractérisés.

Les analyses déjà réalisées par le biais des méthodes dosimétriques existantes, aujourd'hui limitées à des fréquences jusqu'à 6 GHz, utilisent classiquement des dispositifs visant à simuler le comportement du corps humain et notamment les capacités d'absorption et de réflexion des tissus. Ces dispositifs sont communément appelés « phantoms » (de l'anglais) ou « fantômes » (en français). Différentes catégories de « phantoms » existent, telles que, par exemple, les « liquid phantoms », les « semi-solid phantoms» et les « solid phantoms ». Ces dispositifs de laboratoire permettent de simuler différents profils de tissus humains ayant des propriétés diélectriques variées et sont configurés pour permettre des expérimentations dans des gammes de fréquences allant de 30 MHz à 6 GHz. Les « liquid phantoms » sont constitués d'une enveloppe (ou carapace) remplie d'un gel ou d'un liquide ayant des propriétés proches de celles du corps humain. Ils sont généralement utilisés de 30MHz à 6 GHz, mais ne présentent que peu d'intérêt à des fréquences supérieures à 6 GHz et dans le domaine des ondes millimétriques. En effet, la profondeur de pénétration n'est plus que d'un demi-millimètre environ à 60 GHz. D'autres « phantoms », dit semi-solides comprennent de l'eau, et permettent de simuler des tissus biologiques tels que les muscles, le cerveau, la peau, par exemple, mais souffrent d'un problème de longévité lié à un phénomène d'évaporation de l'eau et de la dégradation de leurs propriétés diélectriques qui en résultent.

Des « phantoms » solides comprennent des éléments céramiques, graphites ou carbones, ou encore des caoutchoucs synthétiques et sont utilisés principalement pour les études des effets des rayonnements en et près de la surface du corps humains. Leurs avantages principaux sont leur fiabilité et la constance de leurs propriétés diélectriques à travers le temps. Malheureusement ces « phantoms » solides ont l'inconvénient d'être onéreux et de requérir des conditions drastiques pour leur fabrication, dont notamment des températures élevées et des pressions importantes.

Aucun « phantom » solide ayant des propriétés électromagnétiques équivalentes à celles du corps humain (en termes de permittivité complexe et de conductivité) et exploitable au-dessus de 6 GHz, n'existe aujourd'hui.

Le document « Solid Phantom for Body-Centric Propagation Measurements at 60 GHz » (IEEE transactions on microwaves theory and techniques, VOL. 62, N°6, june 2014) propose un « phantom » solide sur la base d'un substrat en polydimethylsiloxane (PDMS) comprenant de la poudre de carbone noir métallisée sur l'un de ses côtés. Ce « phantom » est configuré pour simuler le comportement du corps humain en surface, soumis à des rayonnements dans des gammes de fréquences autour de 60 GHz. Si le phantom décrit dans ce document offre de bonnes capacités de simulation des caractéristiques de réflexion des tissus humains en surface, et notamment de la peau, les mesures sont réalisées à l'aide de capteurs positionnés à une certaine distance du « phantom », du fait de l'utilisation d'un blindage métallisé sous le substrat. Il est alors aisé d'analyser l'onde réfléchie (signal réfléchi) mais il reste toutefois impossible, à l'aide de ce « phantom », de mesurer avec précision les niveaux d'exposition tels que la densité de la puissance incidente ou le débit d'absorption spécifique. US 2013/0099119 A1, FR 2 851 823 et US 2004/0017115 A1 divulguent plusieurs dispositifs de dosimétrie électromagnétique.

Les solutions existantes présentent des inconvénients.

### 3. Résumé de l'invention.

L'invention permet d'améliorer au moins un des inconvénients de l'état de l'art, en proposant un dispositif adapté à des mesures de rayonnements électromagnétiques émis par un émetteur, à des fréquences supérieures à 6 GHz à l'aide de capteurs positionnés à l'intérieur d'un dispositif « phantom » qui simule les caractéristiques de réflexion des tissus biologiques et notamment humains.

A cet effet, il est proposé un dispositif de simulation de caractéristiques de tissus humains pour la dosimétrie électromagnétique, comprenant une épaisseur (couche) de substrat portant un blindage comprenant un ou plusieurs matériaux conducteurs, métallisés ou non, et une épaisseur (couche) d'un matériau diélectrique disposée sur et/ou sous le substrat (préférentiellement sous le substrat), le dispositif comprenant une pluralité d'ouvertures préférentiellement calibrées réalisées dans le blindage et comprenant en outre au moins un réseau de capteurs disposés dans le matériau diélectrique.

Il est à noter que le terme « substrat » décrit ici une épaisseur (couche) de matériau(x) possédant des propriétés intrinsèques, notamment mécaniques mais aussi électriques ou encore électromagnétiques, adaptée à porter d'autres couches de matériaux, ou à leur servir de base. Ce terme n'est ainsi pas à interpréter strictement au sens de celui utilisé dans le domaine des antennes, mais pourrait, par exemple, être remplacé par le terme « superstrat », dans la mesure où, vraisemblablement, sa position est préférentiellement en surface du dispositif.

Selon un mode de réalisation de l'invention, le blindage est métallisé et est de dimensions correspondantes à celles du substrat. En d'autres termes, le blindage / réflecteur couvre la totalité ou la quasi-totalité de la surface du substrat afin d'opérer une réflexion efficace des rayonnements émis.

Selon une variante du mode de réalisation, le blindage est réalisé au moyen d'éléments non métallisés mais susceptibles de former un barrage aux ondes électromagnétiques.

Selon un mode de réalisation de l'invention, le substrat est principalement réalisé en polymère ou résine, organique ou synthétique, tel que le polydimethylsiloxane (PDMS), par exemple.

Selon un mode de réalisation de l'invention, le substrat comprend de la poudre de carbone noir ou encore de la poudre de métal, des nanotubes de carbones, à titre d'exemples non limitatifs.

Selon un mode de réalisation de l'invention, le matériau diélectrique comprend du plastique ou du verre ou encore un polymère. Avantageusement, le matériau diélectrique peut être d'un autre type, considérant que ces propriétés doivent permettre aux capteurs de recevoir des rayonnements émis lors de phases de test.

Selon le mode de réalisation préféré de l'invention, les ouvertures réalisées dans le blindage sont de nombre, de formes et de dispositions quelconques. Avantageusement, les ouvertures sont réalisées dans le blindage en forme de fentes, de croix (lignes croisées), carrées, circulaires, triangulaires ou encore ovales et sont disposées régulièrement dans l'épaisseur du blindage, lequel blindage opère notamment comme un réflecteur.

Selon un mode de réalisation de l'invention, pour chacune des ouvertures du blindage, la plus grande des dimensions de l'ouverture a une valeur comprise entre une fraction de la longueur d'onde et plusieurs longueurs d'onde, en fonction de la forme de l'ouverture.

Avantageusement, les capteurs comprennent des antennes et/ou des sondes adaptées à la réception des signaux transmis par la source située de l'autre côté du blindage électromagnétique.

L'invention concerne également une méthode de dosimétrie électromagnétique qui comprend :
- une émission, de signaux électromagnétiques à une fréquence préférentiellement supérieure à 6 GHz, depuis une source disposée à une distance prédéterminée d'un dispositif de simulation du coefficient de réflexion des tissus pour la dosimétrie électromagnétique comprenant un substrat portant un blindage métallisé, ce blindage comprenant une pluralité d'ouvertures calibrées, et comprenant une couche d'un matériau diélectrique disposée préférentiellement sous le substrat, et,
- une mesure, à partir d'au moins un réseau de capteurs disposés dans ou contre la couche de matériau diélectrique, du côté du substrat opposé à la source.

Les capteurs pouvant être disposés avantageusement entre deux couches empilées de matériau diélectrique.

Avantageusement, la distance prédéterminée entre la source et le dispositif fantôme est comprise dans un intervalle de valeurs allant de 0 millimètres (contact direct) à 100 cm, ces valeurs limites étant comprises dans l'intervalle.

### 4. Liste des figures.

L'invention sera mieux comprise, et d'autres particularités et avantages apparaîtront à la lecture de la description qui va suivre, la description faisant référence aux dessins annexés parmi lesquels :
- La **figure 1** représente un dispositif de simulation configuré pour la dosimétrie électromagnétique selon l'art antérieur.
- La **figure 2** représente un dispositif de simulation configuré pour la dosimétrie électromagnétique à des fréquences dans la bande des 60 GHz par exemple selon un mode de réalisation particulier et non limitatif de l'invention.

### 5. Description détaillée de modes de réalisation de l'invention.

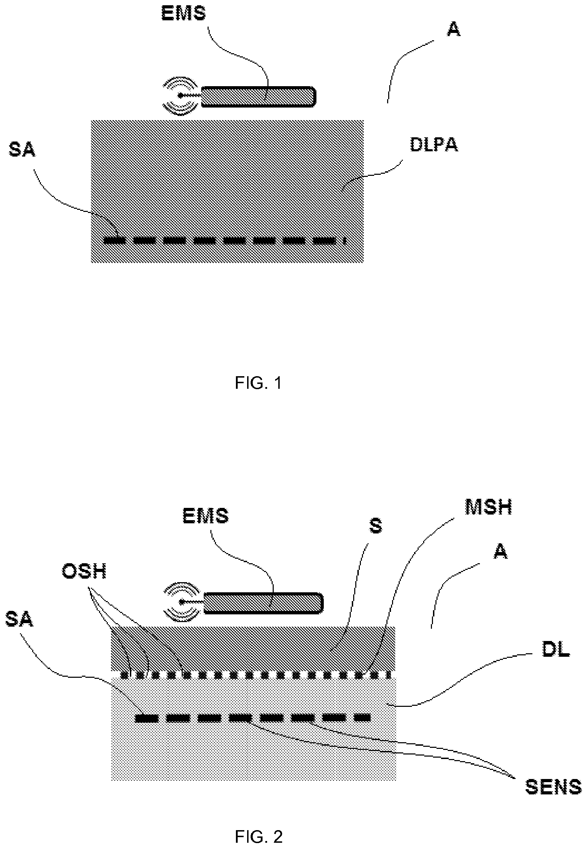

Sur les figures 1 et 2, les modules représentés sont des unités fonctionnelles, qui correspondent ou non à des unités physiquement distinguables. Par exemple, ces modules ou certains d'entre eux sont regroupés dans un unique composant. *A contrario,* selon d'autres modes de réalisation, certains modules sont composés d'entités physiques séparées.

La **figure 1** représente un dispositif A de simulation de caractéristiques de tissus humains configuré pour la dosimétrie électromagnétique selon l'art antérieur. Le dispositif A comprend une couche de matériau diélectrique DLPA à base d'eau ou de gel (comprenant un polymère par exemple) et qui comprend un réseau SA de capteurs SENS dans la couche DLPA.

Le dispositif de la figure 1 permet d'évaluer l'exposition du corps humain à une ou plusieurs antennes émettant des signaux à une fréquence inférieure ou égale à 6 GHz à proximité de celui-ci. Les propriétés diélectriques du dispositif fantôme sont ajustées pour représenter celles des tissus humains dans une gamme de fréquences donnée.
Malheureusement, en l'absence d'une coque, ce type de fantôme se dégrade dans le temps, du fait notamment d'un phénomène d'évaporation dans la couche de matériaux diélectrique DL.

La **figure 2** représente un dispositif configuré pour la dosimétrie électromagnétique selon un mode de réalisation particulier et non limitatif de l'invention et à des fréquences supérieures à 6 GHz et typiquement autour de 60 GHz.

Astucieusement le substrat S porte un blindage MSH opérant comme un réflecteur et comprenant des ouvertures (ou ouïes) préférentiellement calibrées OSH et qui apportent avantageusement une réflectivité (et une « transparence ») électromagnétique de la partie supérieure du fantôme A qui participe à la simulation des caractéristiques de réflexion et dans une moindre mesure des caractéristiques d'absorption de tissus humains, et notamment l'épiderme, le derme et des tissus adipeux situés sous le derme, à des fréquences autour de 60 GHz.

A ces fréquences (au dessus de 6 GHz), l'absorption du rayonnement est limitée aux couches superficielles du corps : à 60 GHz la profondeur de pénétration du rayonnement électromagnétique dans les tissus est de l'ordre de 0,5 mm ; l'absorption est donc essentiellement concentrée dans la peau. L'épiderme absorbe environ 30% de la puissance et le derme en absorbe environ 69% et le reste est absorbé par des tissus adipeux.

Avantageusement, la méthode de mesure qui utilise le fantôme A de la figure 2 comprend une étape d'émission de signaux électromagnétiques à une fréquence préférentiellement supérieure à 6 GHz, et encore plus préférentiellement supérieure à 10 GHz, depuis une source EMS disposée à une distance prédéterminée d1 (non représentée) du dispositif A pour la dosimétrie électromagnétique comprenant le substrat S portant le blindage MSH métallisé, le blindage MSH comprenant un pluralité d'ouvertures OSH calibrées, et le dispositif A comprenant la couche DL d'un matériau diélectrique disposée sous le substrat S.

La méthode comprend aussi et surtout une mesure, à partir d'au moins un réseau SA de capteurs SENS comprenant chacun une ou plusieurs antennes et/ou sondes et disposés dans la couche DL de matériau diélectrique, du côté du substrat S opposé à la source EMS.

Avantageusement, ceci est rendu possible du fait de la réalisation des ouvertures calibrées OSH dans le blindage métallisé MSH, disposé le long du substrat S du dispositif A.

Le substrat S du dispositif A est réalisé, selon un mode de réalisation particulier et non-limitatif de l'invention, en polydimethylsiloxane qui comprend de la poudre de carbone noir.

Les ouvertures OSH sont réalisées en forme de fentes, ou carrées, circulaires, triangulaires ou encore ovales et sont disposées de préférence régulièrement dans l'épaisseur du blindage MSH afin d'amener une transparence relative au rayonnement électromagnétique de la source EMS utilisée.

Selon la méthode, la distance prédéterminée d1 est comprise entre 0 et 100 cm, soit possiblement en contact direct avec le fantôme A.

L'ensemble des détails des opérations techniques de définition des signaux émis et d'analyse des signaux prélevés par le réseau (ou les réseaux) de capteurs n'est pas détaillé plus encore ici, car bien connus de l'homme du métier.

Selon une variante du mode de réalisation de l'invention, une couche de matériau diélectrique DL' peut être disposée à la surface du substrat S. Le matériau diélectrique de cette couche DL peut être identique à celui de la couche DL, ou encore différent.

Avantageusement, le substrat S et la couche de matériau diélectrique DL peuvent être de forme plane ou de forme quelconque, pour simuler tout ou partie du corps humain, par exemple. Ceci s'applique de la même façon pour le blindage.

Selon une variante du mode de réalisation de l'invention, un réseau de capteurs SENS similaire au réseau de capteurs SA est placé dans le substrat blindé métallisé, en plus du réseau situé dans la couche de matériaux diélectrique DL.

Avantageusement, cela permet d'avoir une meilleure appréciation des ondes absorbées à différentes profondeurs du fantôme et donc à différentes profondeur des tissus biologiques humains et notamment de l'épiderme, du derme et de tissus adipeux situé sous le derme.

Selon une autre variante, plusieurs couches de matériaux diélectriques similaire à DL, ayant chacune une permittivité différentes sont empilées et comprennent un ou plusieurs réseaux de capteurs afin d'évaluer l'absorption du rayonnement électromagnétique à différentes profondeurs de l'épiderme et du derme.

L'invention ne se limite pas au seul mode de réalisation décrit ci-avant mais concerne bien évidemment tout dispositif de simulation de caractéristiques de réflexion et d'absorption du corps humain pour la dosimétrie électromagnétique, comprenant un substrat portant un blindage, métallisé ou non, et une couche d'un matériau diélectrique disposée sur et/ou sous ce substrat, et pour lequel le blindage comprend une pluralité d'ouvertures calibrées ; le dispositif comprenant au moins un réseau de capteurs positionnés dans la couche de matériau diélectrique. L'invention concerne également toute méthode mettant en œuvre un dispositif tel que décrit dans les lignes ci-avant.

## Revendications

1. Dispositif (A) pour la dosimétrie électromagnétique, comprenant une couche de substrat (S) portant un blindage (MSH) et une couche (DL) d'un matériau diélectrique disposée sur et/ou sous ladite couche de substrat (S), ledit dispositif (A) étant **caractérisé en ce que** une pluralité d'ouvertures (OSH) sont réalisées dans ledit blindage (MSH) et **en ce qu'**il comprend en outre au moins un réseau (SA) de capteurs (SENS) dans ladite couche (DL) de matériau diélectrique.

2. Dispositif (A) selon la revendication 1, **caractérisé en ce que** ledit substrat (S) est principalement réalisé en polymère ou résine, organique ou synthétique.

3. Dispositif (A) selon l'une quelconque des revendications 1 à 2, **caractérisé en ce que** lesdites ouvertures (OSH) dans le blindage sont réalisées en forme de fentes, ou carrées, circulaires, triangulaires ou encore ovales et sont disposées régulièrement dans l'épaisseur dudit blindage.

4. Dispositif (A) selon l'une quelconque des revendications 1 à 2, **caractérisé en ce que** la plus grande des dimensions desdites ouvertures (OSH) a une valeur comprise entre une fraction de la longueur d'onde et une dizaine de longueurs d'onde.

5. Dispositif (A) selon l'une quelconque des revendications 1 à 4, **caractérisé en ce que** lesdits capteurs (SENS) comprennent des antennes et/ou des sondes.

6. Méthode de dosimétrie électromagnétique, comprenant:
- une émission, de signaux électromagnétiques à une fréquence préférentiellement supérieure à 6 GHz, depuis une source (EMS) disposée à une distance prédéterminée (d1) d'un dispositif (A) pour la dosimétrie électromagnétique comprenant un substrat (S) portant un blindage (MSH), ledit blindage (MSH) comprenant une pluralité d'ouvertures (OSH) calibrées, et ledit dispositif (A) comprenant une couche (DL) d'un matériau diélectrique disposée sur et/ou sous ledit substrat (S),
- une mesure, à partir d'au moins un réseau (SA) de capteurs (SENS) disposés dans ou contre ladite couche (DL) de matériau diélectrique, du côté dudit substrat (S) opposé à ladite source (EMS).

7. Méthode selon la revendication 6, **caractérisée en ce que** ladite distance (d1) prédéterminée, entre ladite source (EMS) et ledit dispositif (A), est comprise dans un intervalle de valeurs allant de 0 millimètre à 100 centimètres, ces valeurs limites étant comprises dans l'intervalle.

## Patentansprüche

1. Vorrichtung (A) für die elektromagnetische Dosimetrie, umfassend eine Substratschicht (S), die eine Abschirmung (MSH) trägt, und eine Schicht (DL) eines dielektrischen Materials, die über und/oder unter der Substratschicht (S) angeordnet ist, wobei die Vorrichtung (A) **dadurch gekennzeichnet ist, dass** eine Vielzahl von Öffnungen (OSH) in die Abschirmung (MSH) eingearbeitet ist und dass sie ferner mindestens ein Netzwerk (SA) von Sensoren (SENS) in der Schicht (DL) dielektrischen Materials umfasst.

2. Vorrichtung (A) nach Anspruch 1, **dadurch gekennzeichnet, dass** das Substrat (S) hauptsächlich aus Polymer oder Wachs, organisch oder synthetisch, hergestellt ist.

3. Vorrichtung (A) nach einem der Ansprüche 1 bis 2, **dadurch gekennzeichnet, dass** die Öffnungen (OSH) in der Abschirmung in Form von kreisförmigen, dreieckigen oder auch ovalen Schlitzen oder Quadraten hergestellt sind und regelmäßig in der Dicke der Abschirmung angeordnet sind.

4. Vorrichtung (A) nach einem der Ansprüche 1 bis 2, **dadurch gekennzeichnet, dass** die größte der Abmessungen der Öffnungen (OSH) einen Wert hat, der zwischen einem Bruchteil der Wellenlänge und einem Dutzend Wellenlängen liegt.

5. Vorrichtung (A) nach einem der Ansprüche 1 bis 4, **dadurch gekennzeichnet, dass** die Sensoren (SENS) Antennen und/oder Sonden umfassen.

6. Elektromagnetische Dosimetriemethode, umfassend:
- ein Senden elektromagnetischer Signale mit einer Frequenz vorzugsweise über 6 GHz ab einer Quelle (EMS), die in einem vorher festgelegten Abstand (d1) von einer Vorrichtung (A) für die elektromagnetische Dosimetrie angeordnet ist, umfassend ein Substrat (S), das eine Abschirmung (MSH) trägt, wobei die Abschirmung (MSH) eine Vielzahl kalibrierter Öffnungen (OSH) umfasst und die Vorrichtung (A) eine Schicht (DL) eines dielektrischen Materials umfasst, das über und/oder unter dem Substrat (S) angeordnet ist,
- ein Messen, ausgehend von mindestens einem Netzwerk (SA) von Sensoren (SENS), die in oder an der Schicht (DL) dielektrischen Materials angeordnet sind, auf der Seite des Substrats (S) entgegengesetzt zur Quelle (EMS).

7. Methode nach Anspruch 6, **dadurch gekennzeichnet, dass** der vorher festgelegte Abstand (d1) zwischen der Quelle (EMS) und der Vorrichtung (A) in einem Werteintervall liegt, das von 0 Millimeter bis 100 Zentimeter reicht, wobei diese Grenzwerte in dem Intervall inbegriffen sind.

## Claims

1. Device (A) for electromagnetic dosimetry, comprising a layer of substrate (S) bearing a shielding (MSH) and a layer (DL) of a dielectric material arranged on and/or beneath said layer of substrate (S), said device (A) being **characterised in that** a plurality of openings (OSH) are made in said shielding (MSH) and **in that** it further comprises at least one array (SA) of sensors (SENS) in said layer (DL) of dielectric material.

2. Device (A) according to claim 1, **characterised in that** said substrate (S) is essentially made of organic or synthetic polymer or resin.

3. Device (A) according to any one of claims 1 to 2, **characterised in that** said openings (OSH) in the shielding are made in slot, or square, circular, triangular or oval shapes and are arranged regularly in the thickness of said shielding.

4. Device (A) according to any one of claims 1 to 2, **characterised in that** the greatest of the dimensions of said openings (OSH) has a value between a fraction of the wavelength and some ten wavelengths.

5. Device (A) according to any one of claims 1 to 4, **characterised in that** said sensors (SENS) comprise antennas and/or probes.

6. Electromagnetic dosimetry method comprising:
- an emission, of electromagnetic signals at a frequency preferentially greater than 6 GHz, from a source (EMS) arranged at a predetermined distance (d1) from a device (A) for electromagnetic dosimetry comprising a substrate (S) bearing a shielding (MSH), said shielding (MSH) comprising a plurality of calibrated openings (OSH), and said device (A) comprising a layer (DL) of a dielectric material arranged on and/or beneath said substrate (S),
- a measurement, using at least one array (SA) of sensors (SENS) arranged in or against said layer (DL) of dielectric material, on the side of said substrate (S) opposite said source (EMS).

7. Method according to claim 6, **characterised in that** said predetermined distance (d1), between said source (EMS) and said device (A), is within a range of values ranging from 0 millimetre to 100 centimetres, these limit values being included in the range.
